# EUROPEAN PATENT APPLICATION

(11) **EP 4 442 484 A1**
(43) Date of publication of application: **09.10.2024**
(21) Application number: 23184118.0
(22) Date of filing: 07.07.2023
(51) Int. Cl.: B60L 53/10, B60L 53/18, B60L 53/302, B60L 53/31, H01B 7/18, H01B 7/22, H01B 7/42, H02G 3/03, H02G 3/04, H02G 15/00, H01R 13/00, H01R 9/11

(54) **CHARGING DEVICE AND LIQUID COOLED CABLE**

(30) Priority: 07.04.2023 TW 112113178
(71) Applicant: Walsin Lihwa Corporation, Taipei City 110411 (TW)
(72) Inventor: CHEN, Ko-Ming, Taipei City 110411 (TW); LIN, Duan-Yih, Taipei City 110411 (TW); CHEN, Cheng-Hong, Taipei City 110411 (TW); WANG, Shih-Wei, Taipei City 110411 (TW); WANG, Shih-Hsiang, Taipei City 110411 (TW)
(74) Representative: Viering, Jentschura & Partner mbB Patent- und Rechtsanwälte

(57) **Abstract**

A charging device includes a liquid cooled cable (100), a charging gun (200), a charging station (300), a station connector (400) and a communicating pipe (500). The liquid cooled cable (100) has a gun end (110) and a station end (120). The liquid cooled cable (100) includes a first insulating tube (130), a second insulating tube (140), a tape, a filler and a sheath. The first insulating tube (130) has a first channel (130a). The second insulating tube (140) has a second channel (140a) and a braided copper mesh (141). The charging gun (200) is connected to the gun end (110) of the liquid cooled cable (100). The charging gun (200) includes a gun connector (210) and a first liquid return channel. The station connector (400) includes a second liquid return channel and a connection part (420). One end of the second liquid return channel communicates to the second channel (140a). The connection part (420) is connected to the station end (120) of the liquid cooled cable (100).

## Description

### BACKGROUND

### Technical Field

The disclosure relates to a charging device and a liquid cooled cable, in particular to a liquid cooled charging device and a liquid cooled cable.

### Related Art

Nowadays, with the development of civilization, there are more and more products that need to be charged, for example, electric vehicles. In the related art, the electric vehicles are mostly charged by setting up charging stations. However, during the charging process, the whole device is prone to overheating and causing danger. In particular, the cable and its connection end are particularly prone to overheating during the charging process.

### SUMMARY

In view of this, according to some embodiments, the disclosure provides a charging device, including a liquid cooled cable, a charging gun, a charging station, a station connector and a communicating pipe. The liquid cooled cable has a gun end and a station end. The liquid cooled cable includes a first insulating tube, a second insulating tube, a tape, a filler and a sheath. The first insulating tube has a first channel. The second insulating tube has a second channel and a braided copper mesh. The second channel is located in the braided copper mesh. The tape covers the first insulating tube and the second insulating tube. The filler is located in the tape and filled between the first insulating tube and the second insulating tube. The sheath covers the tape. The charging gun is connected to the gun end of the liquid cooled cable and includes a gun connector and a first liquid return channel. The gun connector is electrically connected to the braided copper mesh, and the first liquid return channel communicates to the first channel and the second channel. The charging station includes a cooling module and a charging module. The cooling module includes a liquid inlet and a liquid outlet. The liquid inlet is connected to the station end of the liquid cooled cable and communicates to the first channel. The station connector includes a second liquid return channel and a connection part. One end of the second liquid return channel communicates to the second channel. The connection part is connected to the station end of the liquid cooled cable and electrically connected to the braided copper mesh. Two ends of the communicating pipe are respectively connected to the other end of the second liquid return channel and the liquid outlet of the cooling module.

In some embodiments, the liquid cooled cable includes two first insulating tubes and two second insulating tubes.

In some embodiments, the gun connector further includes a gun connector body, a gun connection part, a first end part, a second end part and a lid. The first liquid return channel is located in the gun connector body. The gun connection part is connected to the gun connector body. The first end part communicates to one end of the first liquid return channel and is electrically connected to the braided copper mesh. The second end part communicates to the other end of the first liquid return channel and communicates to the first channel. The lid is connected to the gun connector body and covers the first liquid return channel.

In some embodiments, the charging device further includes a first ferrule, having one end connected to the first end part and the other end connected to the braided copper mesh.

In some embodiments, the charging device further includes a first crimping member and two first anti-leakage rings. One of the first anti-leakage rings is sleeved outside the braided copper mesh and located at a joint between the first ferrule and the braided copper mesh. The other first anti-leakage ring is sleeved on the first end part. The first crimping member is sleeved on the braided copper mesh, the first end part and the two first anti-leakage rings.

In some embodiments, the station connector further includes a station connector body, an adapting part, a station connection part and a cover plate. The second liquid return channel is located in the station connector body, and the connection part communicates to one end of the second liquid return channel and is electrically connected to the braided copper mesh. The adapting part communicates to the other end of the second liquid return channel and communicates to the communicating pipe. The station connection part is connected to the station connector body and electrically connected to the charging module. The cover plate is connected to the station connector body and covers the second liquid return channel.

In some embodiments, the charging device further includes a second ferrule, having one end connected to the connection part and the other end connected to the braided copper mesh.

In some embodiments, the charging device further includes a second crimping member and two second anti-leakage rings. One of the second anti-leakage rings is sleeved outside the braided copper mesh and located at a joint between the second ferrule and the hollow braided copper mesh. The other second anti-leakage ring is sleeved on the connection part. The second crimping member is sleeved on the braided copper mesh, the connection part and the two second anti-leakage rings.

In some embodiments, the braided copper mesh is a double-layer braided structure or a multi-layer braided structure.

In some embodiments, a braiding density of the braided copper mesh ranges from 70% to 90%.

According to some embodiments, the disclosure further provides a liquid cooled cable having a gun end and a station end. The liquid cooled cable includes a first insulating tube, a second insulating tube, a tape, a filler and a sheath. The first insulating tube has a first channel. The second insulating tube has a second channel and a braided copper mesh. The second channel is located in the braided copper mesh. The tape covers the first insulating tube and the second insulating tube. The filler is located in the tape and filled between the first insulating tube and the second insulating tube. The sheath covers the tape.

In some embodiments, the liquid cooled cable further includes a charging gun. The charging gun includes a gun connector and a first liquid return channel. The gun connector is electrically connected to the braided copper mesh, and the first liquid return channel communicates to the first channel and the second channel.

In some embodiments, the liquid cooled cable further includes a station connector. The station connector includes a second liquid return channel and a connection part. One end of the second liquid return channel communicates to the second channel, and the connection part is electrically connected to the braided copper mesh.

In some embodiments, the liquid cooled cable further includes two first insulating tubes and two second insulating tubes.

In some embodiments, the liquid cooled cable further includes a charging gun. The charging gun includes two gun connectors and two first liquid return channels. Each of the gun connectors is electrically connected to one of the braided copper meshes, and each of the first liquid return channels communicates to one of the first channels and one of the second channels.

In some embodiments, the liquid cooled cable further includes two station connectors. Each of the station connectors includes a second liquid return channel and a connection part. One end of the second liquid return channel communicates to one of the second channels, and the connection part is electrically connected to one of the braided copper meshes.

In some embodiments, the braided copper mesh is a double-layer braided structure or a multi-layer braided structure.

In some embodiments, a braiding density of the braided copper mesh ranges from 70% to 90%.

The detailed features and advantages of the disclosure are set forth in the detailed description of the embodiments of the disclosure, the content of which is sufficient for any person skilled in the art to understand the technical content of the disclosure and implement it based thereon. According to the contents, scope and drawings disclosed in this specification, any person skilled in the art can easily understand the objects and advantages associated with the disclosure.

### BRIEF DESCRIPTION OF THE DRAWINGS

FIG. 1 is a schematic diagram showing the appearance of a charging device according to some embodiments;
FIG. 2 is a block diagram of a charging station according to some embodiments;
FIG. 3 is a schematic diagram showing the charging device and the flow of a liquid coolant according to some embodiments;
FIG. 4 is a sectional view of a liquid cooled cable according to some embodiments;
FIG. 5 is a schematic diagram of a gun connector according to some embodiments;
FIG. 6 is an exploded view of the gun connector according to some embodiments;
FIG. 7 is a schematic diagram of the gun connector connected to a second insulating tube according to some embodiments;
FIG. 8 is a schematic diagram of a cooling module according to some embodiments;
FIG. 9 is a schematic diagram of a station connector according to some embodiments; and
FIG. 10 is a schematic diagram of the station connector connected to the second insulating tube according to some embodiments.

### DETAILED DESCRIPTION

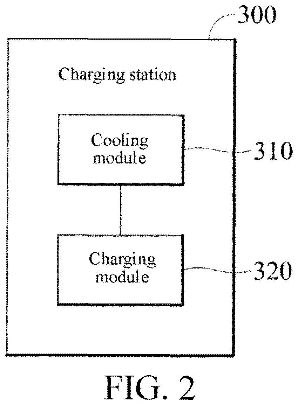

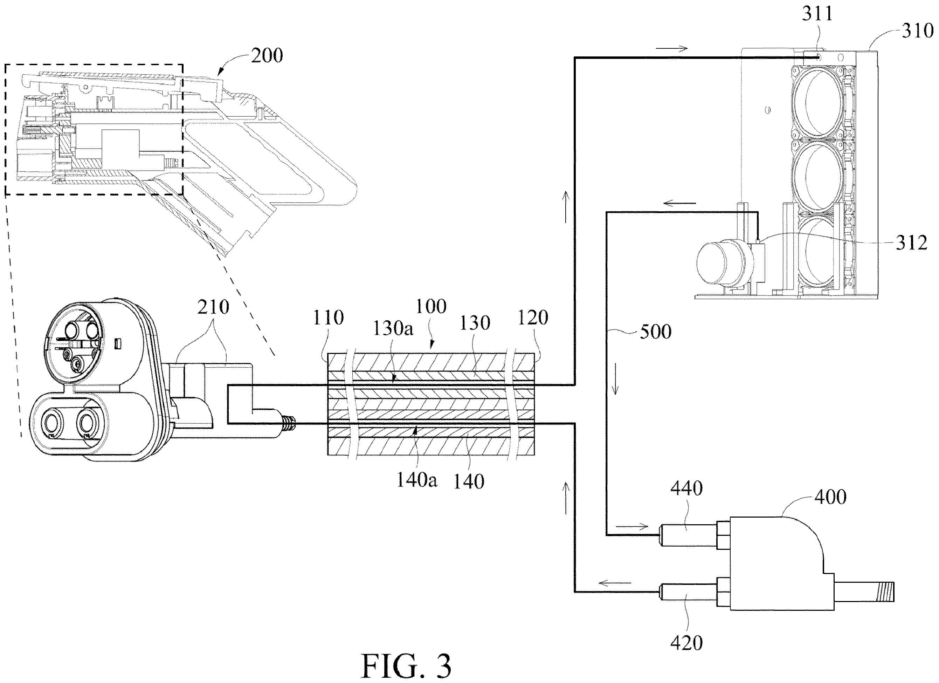

Referring to FIG. 1, FIG. 2 and FIG. 3, FIG. 1 is a schematic diagram showing the appearance of a charging device according to some embodiments. FIG. 2 is a block diagram of a charging station according to some embodiments. FIG. 3 is a schematic diagram showing the charging device and the flow of a liquid coolant according to some embodiments. The charging device includes a liquid cooled cable 100, a charging gun 200, a charging station 300, a station connector 400 and a communicating pipe 500. In an embodiment, as shown in FIG. 3, the arrows represent the flow direction of the liquid coolant. The connection lines between the elements represent pipe connections. For example, the communicating pipe 500 is connected between a cooling module 310 and the station connector 400, or the liquid cooled cable 100 is connected to the charging gun 200.

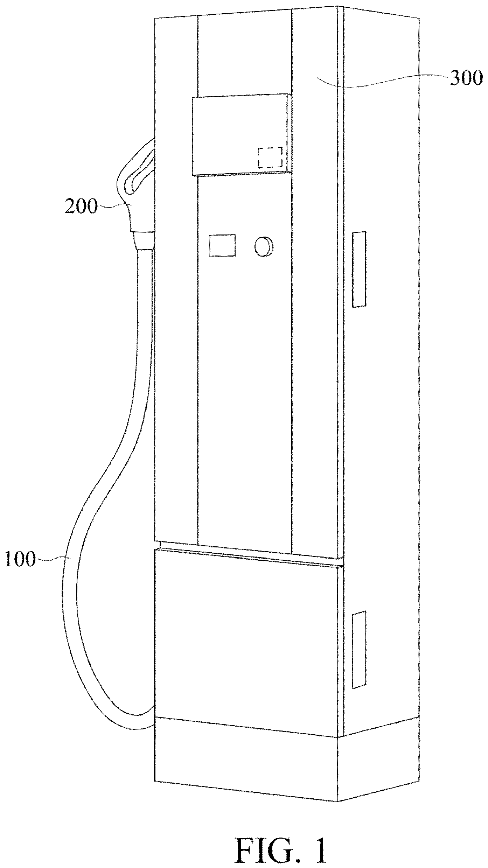

Referring to referring to FIG. 1 to FIG. 4, FIG. 4 is a sectional view of a liquid cooled cable according to some embodiments. The liquid cooled cable 100 has a gun end 110 and a station end 120 (as shown in FIG. 3). Based on this, the liquid cooled cable 100 includes a first insulating tube 130, a second insulating tube 140, a tape 150, a filler160 and a sheath 170.

The first insulating tube 130 has a first channel 130a. The first insulating tube 130 is a liquid return tube, which may be made of an anti-leakage material, such as PP. Here, since the first insulating tube 130 has the first channel 130a, a liquid, such as a liquid coolant, can flow in the first insulating tube 130. In an embodiment, the liquid coolant is, for example, but not limited to, esters, which are electrically insulated and have good heat dissipation effect. Moreover, the esters do not react with the first insulating tube 130, the second insulating tube 140 or other conductors.

The second insulating tube 140 has a second channel 140a and a braided copper mesh 141. In some embodiments, the second channel 140a is located in the braided copper mesh 141. Further, the braided copper mesh 141 is shaped a hollow tube inside the second insulating tube 140, and the second channel 140a is formed at the center of the braided copper mesh 141. In some embodiments, the second insulating tube 140 may be made of PE XLPE, EPR, PVC, etc. Here, since the second insulating tube 140 has the second channel 140a, a liquid, such as a liquid coolant, can flow in the second insulating tube 140. Moreover, in some embodiments, since the second channel 140a is located in the braided copper mesh 141, when the liquid coolant flows in the second insulating tube 140, the liquid coolant can fully contact the braided copper mesh 141, so that the braided copper mesh 141 can obtain the best cooling effect. Further, the braided copper mesh 141 is shaped a hollow tube inside the second insulating tube 140 as a conductor, and in some embodiments, a braided density of the braided copper mesh 141 ranges from 70% to 90%. Therefore, the braided copper mesh 141 supports the second channel 140a to avoid blockage due to compressional deformation.

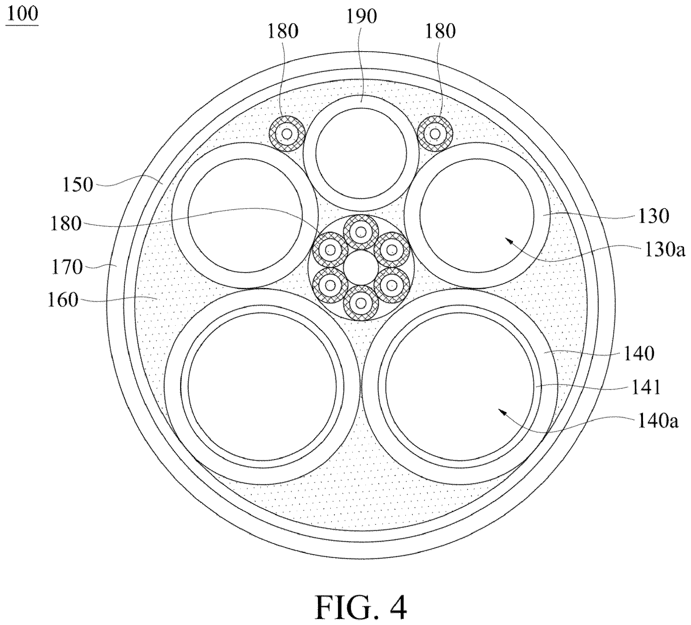

In some embodiments, the braided copper mesh 141 is, for example, but not limited to, a soft stranded copper braided copper mesh or a hollow braided copper mesh. In an embodiment, the braided copper mesh 141 is a double-layer braided structure. In some embodiments, considering the heat dissipation efficiency, charging efficiency and cable durability, the braided copper mesh 141 is a three-layer structure or multi-layer braided structure. In addition, a braiding density of the braided copper mesh 141 ranges from 70% to 90%. In some embodiments, the liquid cooled cable 100 includes two first insulating tubes 130 and two second insulating tubes 140 (as shown in FIG. 4). When the charging device has a positive electrode and a negative electrode, one of the first insulating tubes 130 and one of the second insulating tubes 140 correspond to the positive electrode. The other first insulating tube 130 and the other second insulating tube 140 correspond to the negative electrode.

The tape 150 covers the first insulating tube 130 and the second insulating tube 140. In some embodiments, the tape 150 is made of a non-woven fabric, which is used for initially fixing lines in the liquid cooled cable 100 and maintaining their shape and then covered by the sheath 170. In other embodiments, the tape 150 covers a filler 160 therein (described in detail later), and based on this, the tape 150 can further cover the filler 160 so as to shape the filler 160. Further, the filler 160 is covered by the tape 150 so that the whole filler 160 does not become loosened.

As shown in FIG. 4, the filler 160 is located in the tape 150 and filled between the first insulating tube 130 and the second insulating tube 140. The sheath 170 covers the tape 150. In some embodiments, the filler 160 is, for example, but not limited to, a PP tape, which is filled the tape 150 and occupies the whole space formed in the tape 150. Based on this, the first insulating tube 130 and the second insulating tube 140 are surrounded by the filler 160. Besides, after the filling of the filler 160, when the first insulating tube 130 and the second insulating tube 140 are covered by the sheath 170 (or the tape 150), the first insulating tube 130 and the second insulating tube 140 cannot move freely in the sheath 170 (or the tape 150) due to the filling of the filler 160. In some embodiments, the sheath 170 is made of, for example, but not limited to, CR, TPU, LSHF, etc.

In some embodiments, the liquid cooled cable 100 further include at least one signal line 180, which can be configured to transmit electrical signals. In some embodiments, the signal line 180 includes a conductor (e.g., a copper wire) or an optical fiber. For example, the signal line 180 sequentially includes a conductor, an insulator and a tinned copper braided mesh from inside to outside. In an embodiment, as shown in FIG. 4, the number of the signal lines 180 is 8, and may actually be 6 to 8. Moreover, 6 of the signal lines 180 may be additionally bundled by the insulator into a whole (the signal lines 180 at the center in FIG. 4). In other embodiments, the liquid cooled cable 100 further includes a ground wire 190, which may be formed by a conductor (e.g., a copper wire) covered with an insulator at the outermost layer. Here, the insulator is made of, for example, but not limited to, PE, XLPE, EPR, PVC, etc. Based on this, the filler 160 is located in the tape 150 and filled between the signal lines 180 and the ground wire 190. Further, the first insulating tube 130, the second insulating tube 140, the signal lines 180 and the ground wire 190 cannot move freely in the sheath 170 (or the tape 150) due to the filling of the filler 160.

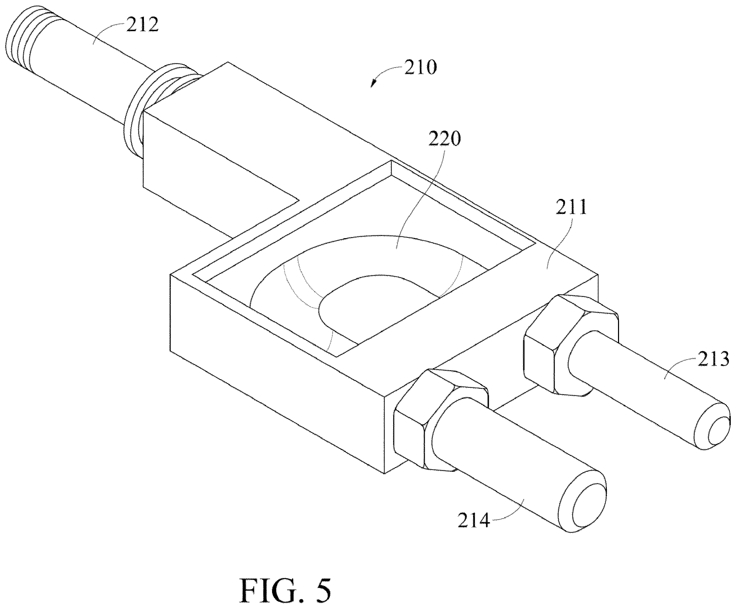

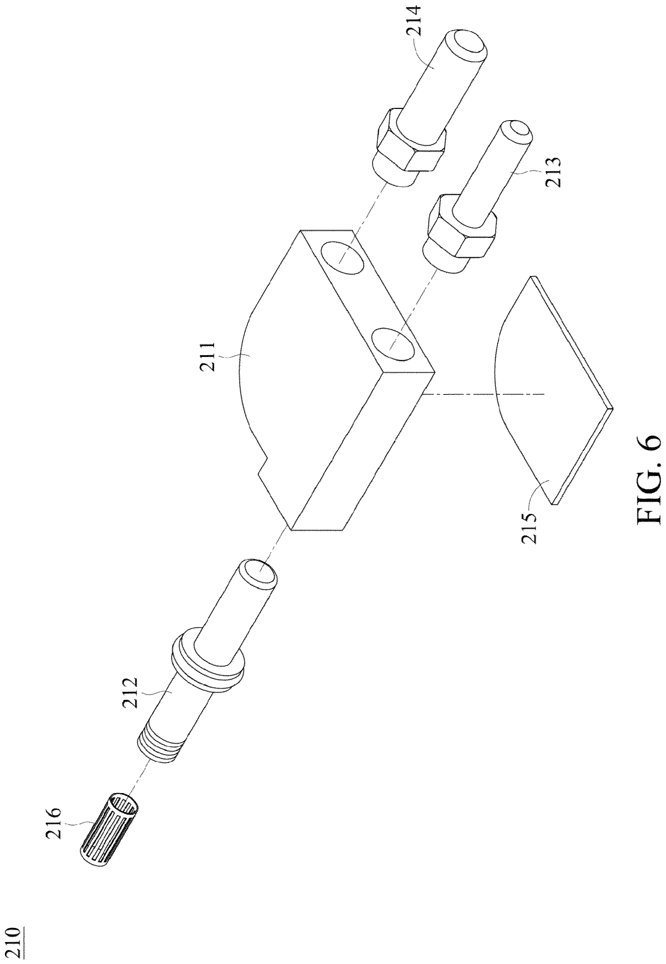

Referring to FIG. 3, FIG. 5 and FIG. 6, FIG. 5 is a schematic diagram of a gun connector according to some embodiments. FIG. 6 is an exploded view of the gun connector according to some embodiments. As shown in FIG. 3, the charging gun 200 is connected to the gun end 110 of the liquid cooled cable 100. The charging gun 200 includes a gun connector 210 and a first liquid return channel 220. The gun connector 210 is electrically connected to the braided copper mesh 141, and the first liquid return channel 220 communicates to the first channel 130a and the second channel 140a. As shown in FIG. 6, the gun connector 210 further includes a gun connector body 211, a gun connection part 212, a first end part 213, a second end part 214 and a lid 215 (not shown in FIG. 5). In some embodiments, the gun connector 210 may not include the second end part 214 (as shown in FIG. 3). Further, the first end part 213 is configured to communicate to the second channel 140a. The second end part 214 is configured to communicate to the first channel 130a. Based on this, when the gun connector 210 has only one opening (does not include the second end part 214, as shown in FIG. 3), this opening may also communicate to the first channel 130a. Further, the gun connector 210 may be provided with only two openings that respectively communicate to the first channel 130a and the second channel 140a.

The gun connector body 211, the gun connection part 212, the first end part 213 and the second end part 214 are made of electrical conductors, for example, but not limited to, metal materials. The first liquid return channel 220 is located in the gun connector body 211, and the gun connection part 212 is connected to the gun connector body 211. Besides, the gun connection part 212 may be connected to the gun connector body 211 by soldering or screwing. In some embodiments, the first liquid return channel 220 is, for example, but not limited to, an approximately arc-shaped channel, such as a U-shaped channel. Further, two ends of the first liquid return channel 220 are respectively located on one side of the gun connector body 211. As shown in FIG. 6, the two ends of the first liquid return channel 220 form two openings on one side of the gun connector body 211. The gun connection part 212 is located on the other side of the gun connector body 211 corresponding to the two openings. In some embodiments, the first end part 213 may be connected to the gun connector body 211 by soldering or screwing, so that the first end part 213 communicates to one end of the first liquid return channel 220 and is further electrically connected to the braided copper mesh 141. In some embodiments, the first end part 213 is, for example, but not limited to, a hollow tube made of a metal material.

The second end part 214 communicates to the other end of the first liquid return channel 220 and communicates to the first channel 130a. In some embodiments, the second end part 214 is, for example, but not limited to, a hollow tube made of a metal material. Besides, the second end part 214 may be connected to the gun connector body 211 by soldering or screwing. In other embodiments, the first end part 213 needs to be electrically connected to the braided copper mesh 141, so the diameter of the first end part 213 is less than the diameter of the second end part 214.

As shown in FIG. 6, the shape of the lid 215 is, for example, but not limited to, corresponding to the shape of the gun connector body 211. In an embodiment, as shown in FIG. 5, the lid 215 (not shown) is in the shape of a rectangle. In some embodiments, the lid 215 is made of, for example, but not limited to, a metal material, and may be connected to the gun connector body 211 by soldering and cover the first liquid return channel 220. Based on this, when the liquid coolant flows in the first liquid return channel 220, it will not overflow out of the gun connector body 211. In other embodiments, the gun connector 210 further includes a crown spring 216, which is arranged on the gun connection part 212. Here, the crown spring 216 is, for example, but not limited to, a high-current low-resistance elastic element.

In some embodiments, the liquid cooled cable 100 includes two first insulating tubes 130 and two second insulating tubes 140. Therefore, the charging gun 200 includes two gun connectors 210 (as shown in FIG. 3) and two first liquid return channels 220. Each gun connector 210 is electrically connected to one of the braided copper meshes 141, and each first liquid return channel 220 communicates to one of the first channels 130a and one of the second channels 140a. Further, one first insulating tube 130 and one second insulating tube 140 correspondingly communicate (is connected) to a gun connector 210.

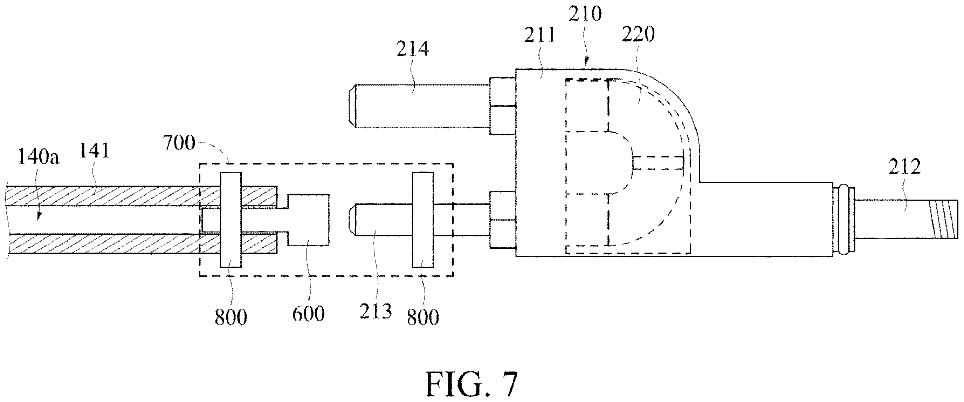

Referring to FIG. 7, FIG. 7 is a schematic diagram of the gun connector connected to the second insulating tube according to some embodiments. The charging device further includes a first ferrule 600, having one end connected to the first end part 213 and the other end connected to the braided copper mesh 141. Here, the thinner end of the first ferrule 600 is arranged in the center of the braided copper mesh 141 as a support, so that the second channel 140a is kept unblocked after being crimped. Based on this, the charging device further includes a first crimping member 700 and two first anti-leakage rings 800. One of the first anti-leakage rings 800 is sleeved outside the braided copper mesh 141 and located at a joint between the first ferrule 600 and the braided copper mesh 141. The other first anti-leakage ring 800 is sleeved on the first end part 213. The first crimping member 700 is sleeved on the braided copper mesh 141, the first end part 213 and the two first anti-leakage rings 800. Further, the first anti-leakage rings 800 are arranged outside the braided copper mesh 141, sleeved with the first crimping member 700 and then subjected to riveting, thereby avoiding leakage of the liquid coolant. In some embodiments, the first crimping member 700 is made of, for example, but not limited to, a metal material. In other embodiments, the first anti-leakage rings 800 are made of, for example, but not limited to, a rubber material.

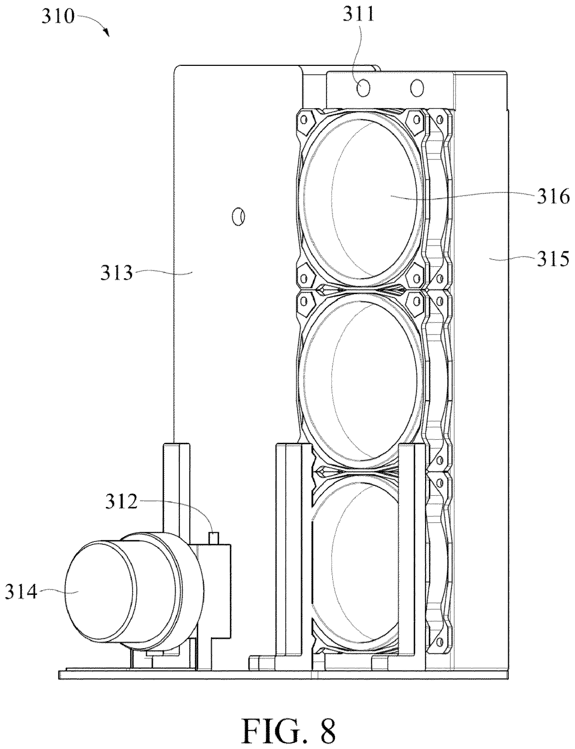

Referring to FIG. 2, FIG. 3 and FIG. 8, FIG. 8 is a schematic diagram of a cooling module according to some embodiments. The charging station 300 includes a cooling module 310 and a charging module 320. The charging module 320 is configured to provide power. The cooling module 310 includes a liquid inlet 311 and a liquid outlet 312. The liquid inlet 311 is connected to the station end 120 of the liquid cooled cable 100 and communicates to the first channel 130a. In some embodiments, the cooling module 310 further includes a liquid tank 313, a pump 314, a radiator 315 and a fan 316. The liquid tank 313 is configured to store the liquid coolant. The pump 314 is configured to extract the liquid coolant from the liquid tank 313 and discharge the liquid coolant from the liquid outlet 312. The radiator 315 and the fan 316 are configured to cool the liquid coolant flowing back from the liquid inlet 311.

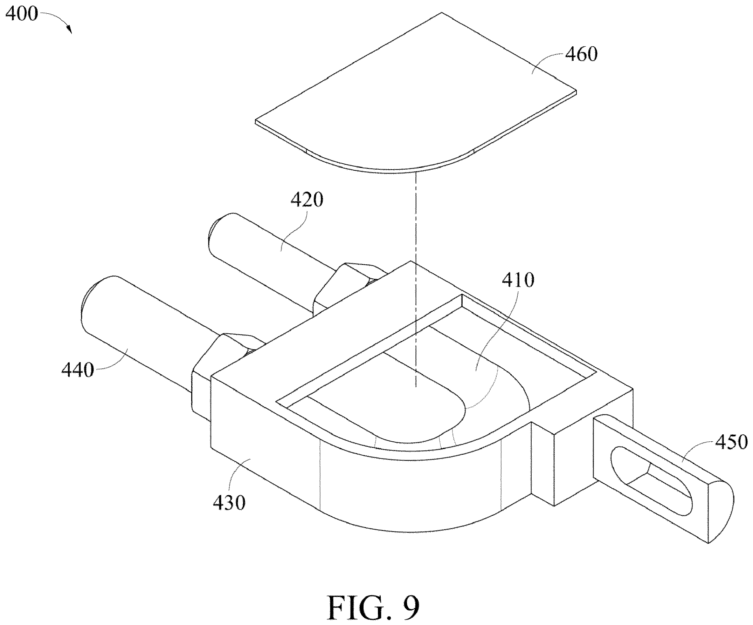

Referring to FIG. 3 and FIG. 9, FIG. 9 is a schematic diagram of a station connector according to some embodiments. As shown in FIG. 9, the station connector 400 includes a second liquid return channel 410 and a connection part 420. One end of the second liquid return channel 410 communicates to the second channel 140a, and the connection part 420 is connected to the station end 120 of the liquid cooled cable 100 and electrically connected to the braided copper mesh 141. Two ends of the communicating pipe 500 respectively communicate to the other end of the second liquid return channel 410 and the liquid outlet 312 of the cooling module 310. In some embodiments, the station connector 400 further includes a station connector body 430, an adapting part 440, a station connection part 450 and a cover plate 460. In some embodiments, the structure of the station connector 400 is the same as that of the gun connector 210, and the appearance of the station connector 400 may be the same as or different from that of the gun connector 210. In some embodiments, the station connector 400 and the gun connector 210 are different only in the styles of the station connection part 450 and the gun connection part 212.

The station connector 400 is made of electrical conductors, for example, but not limited to, metal materials. The second liquid return channel 410 is located in the station connector body 430, and the connection part 420 communicates to one end of the second liquid return channel 410 and is electrically connected to the braided copper mesh 141. In some embodiments, the second liquid return channel 410 is, for example, but not limited to, an approximately arc-shaped channel, such as a U-shaped channel. The adapting part 440 communicates to the other end of the second liquid return channel 410 and communicates to the communicating pipe 500. The station connection part 450 is connected to the station connector body 430 and electrically connected to the charging module 320. Further, two ends of the second liquid return channel 410 respectively form two openings on one side of the station connector body 430, and the station connection part 450 is located on the other side of the station connector body 430 corresponding to the two openings of the second liquid return channel 410. Based on this, the connection part 420 and the adapting part 440 are respectively connected to the two openings and communicate to the second liquid return channel 410. In some embodiments, the connection part 420 and the adapting part 440 are for example, but not limited to, hollow tubes made of metal materials. Besides, the connection part 420 and the adapting part 440 may be connected to the station connector body 430 by soldering or screwing. In other embodiments, the connection part 420 needs to be electrically connected to the braided copper mesh 141, so the diameter of the connection part 420 is less than the diameter of the adapting part 440.

The shape of the cover plate 460 corresponds to the shape of the station connector body 430. In some embodiments, the cover plate 460 is made of, for example, but not limited to, a metal material, and may be connected to the station connector body 430 by soldering and cover the second liquid return channel 410. Based on this, when the liquid coolant flows in the second liquid return channel 410, it will not overflow out of the station connector body 430.

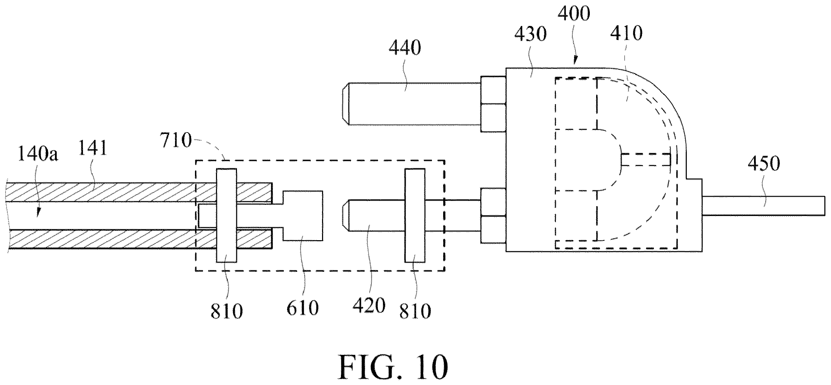

Referring to FIG. 10, FIG. 10 is a schematic diagram of the station connector connected to the second insulating tube according to some embodiments. The charging device further includes a second ferrule 610, having one end connected to the connection part 420 and the other end connected to the braided copper mesh 141. Here, the thinner end of the second ferrule 610 is arranged in the center of the braided copper mesh 141 as a support, so that the second channel 140a is kept unblocked after being crimped. Based on this, the charging device further includes a second crimping member 710 and two second anti-leakage rings 810. One of the second anti-leakage rings 810 is sleeved outside the braided copper mesh 141 and located at a joint between the second ferrule 610 and the braided copper mesh 141. The other second anti-leakage ring 810 is sleeved on the connection part 420. The second crimping member 710 is sleeved on the braided copper mesh 141, the connection part 420 and the two second anti-leakage rings 810. Further, the second anti-leakage rings 810 are arranged outside the braided copper mesh 141, sleeved with the second crimping member 710 and then subjected to riveting, thereby avoiding leakage of the liquid coolant. In some embodiments, the second crimping member 710 is made of, for example, but not limited to, a metal material. In other embodiments, the second anti-leakage rings 810 are made of, for example, but not limited to, a rubber material.

In some embodiments, the liquid cooled cable 100 includes two first insulating tubes 130 and two second insulating tubes 140. Therefore, there are two station connectors 400. Each station connector 400 is electrically connected to one of the braided copper meshes 141, and each second liquid return channel 410 communicates to one of the second channels 140a and the communicating pipe 500. In other embodiments, the communicating pipe 500 may be respectively connected to the second liquid return channels 410 of the two station connectors 400 via a three-way connector; or there are two communicating pipes 500, and each communicating pipe 500 is connected to one second liquid return channel 410.

For example, in FIG. 3, the cooling module 310 can provide liquid coolant output. The liquid coolant flows to the station connector 400 via the communicating pipe 500, flows through the second liquid return channel 410 (as shown in FIG. 10), and flows out via the connection part 420. Based on this, the liquid coolant further flows into the second insulating tube 140, and flows through the second insulating tube 140 and flows into the gun connector 210. After flowing into the gun connector 210, the liquid coolant flows through the first liquid return channel 220 and flows out via the second end part 214 (as shown in FIG. 5). Based on this, the liquid coolant further flows into the first insulating tube 130, and flows through the insulating tube 130 and flows into the cooling module 310. Based on the above, according to the liquid cooled cable 100, the braided copper mesh 141 is used as the conductor, and a space (the second channel 140a) for containing the liquid coolant is formed therein. The braided copper mesh 141 is covered with the insulator, so that the liquid coolant can fully contact the braided copper mesh 141 to obtain the best cooling effect. Besides, due to the arrangement of the second liquid return channel 410 and the first liquid return channel 220, the liquid coolant flowing into the second liquid return channel 410 and the first liquid return channel 220 can cool the station connector 400 and the gun connector 210.

Referring to FIG. 3, FIG. 4, FIG. 5 and FIG. 9, according to some embodiments, the disclosure further provides a liquid cooled cable 100 having a gun end 110 and a station end 120. In some embodiments, the liquid cooled cable 100 further includes a charging gun 200. The charging gun 200 includes a gun connector 210 and a first liquid return channel 220. The liquid cooled cable 100 further includes a station connector 400. The station connector 400 includes a second liquid return channel 410 and a connection part 420. The structures of the liquid cooled cable 100, the charging gun 200, the gun connector 210 and the station connector 400 are all as described above, and will not be repeated here.

In some embodiments, the liquid cooled cable 100 further includes a charging gun 200, and the liquid cooled cable 100 includes two first insulating tubes 130 and two second insulating tubes 140. Besides, the charging gun 200 includes two gun connectors 210 (as shown in FIG. 3) and two first liquid return channels 220. Each gun connector 210 is electrically connected to one of the braided copper meshes 141, and each first liquid return channel 220 communicates to one of the first channels 130a and one of the second channels 140a. Further, one first insulating tube 130 and one second insulating tube 140 correspondingly communicate (is connected) to a gun connector 210.

In some embodiments, the liquid cooled cable 100 includes two first insulating tubes 130 and two second insulating tubes 140. Besides, the liquid cooled cable 100 further includes two station connectors 400. Each station connector 400 includes a second liquid return channel 410 and a connection part 420. Each station connector 400 is electrically connected to one of the braided copper meshes 141. Each second liquid return channel 410 communicates to one of the second channels 140a.

Based on the above, in some embodiments, according to the liquid cooled cable of the charging device of the embodiments of the disclosure, the braided copper mesh used as the conductor is covered with the insulator, so that the liquid coolant can fully contact the braided copper mesh to obtain the best cooling effect. Besides, due to the arrangement of the first liquid return channel and the second liquid return channel, the liquid coolant flowing into the second liquid return channel and the first liquid return channel can cool the station connector and the gun connector. Therefore, the problem of overheating of the device during the charging process in the related art is solved. Moreover, the problem of overheating at the cable and its connection end due to charging is solved.

## Claims

1. A charging device, comprising:
a liquid cooled cable (100) having a gun end (110) and a station end (120), comprising:
a first insulating tube (130), having a first channel (130a);
a second insulating tube (140), having a second channel (140a) and a braided copper mesh (141), the second channel (140a) being located in the braided copper mesh (141);
a tape (150), covering the first insulating tube (130) and the second insulating tube (140);
a filler (160), located in the tape (150) and filled between the first insulating tube (130) and the second insulating tube (140); and
a sheath (170), covering the tape (150);
a charging gun (200), connected to the gun end (110) of the liquid cooled cable (100) and comprising a gun connector (210) and a first liquid return channel (220), the gun connector (210) being electrically connected to the braided copper mesh (141), and the first liquid return channel (220) communicating to the first channel (130a) and the second channel (140a);
a charging station (300), comprising:
a cooling module (310), comprising a liquid inlet (311) and a liquid outlet (312), the liquid inlet (311) being connected to the station end (120) of the liquid cooled cable (100) and communicating to the first channel (130a); and
a charging module (320);
a station connector (400), comprising a second liquid return channel (410) and a connection part (420), one end of the second liquid return channel (410) communicating to the second channel (140a), and the connection part (420) being connected to the station end (120) of the liquid cooled cable (100) and electrically connected to the braided copper mesh (141); and
a communicating pipe (500), two ends of the communicating pipe (500) respectively communicating to the other end of the second liquid return channel (410) and the liquid outlet (312) of the cooling module (310).

2. The charging device according to claim 1, wherein the liquid cooled cable (100) comprises two first insulating tubes (130) and two second insulating tubes (140).

3. The charging device according to claim 1, wherein the gun connector (210) further comprises:
a gun connector body (211), the first liquid return channel (220) being located in the gun connector body (211);
a gun connection part (212), connected to the gun connector body (211);
a first end part (213), communicating to one end of the first liquid return channel (220) and electrically connected to the braided copper mesh (141);
a second end part (214), communicating to the other end of the first liquid return channel (220) and communicating to the first channel (130a); and
a lid (215), connected to the gun connector body (211) and covering the first liquid return channel (220).

4. The charging device according to claim 3, further comprising a first ferrule (600), having one end connected to the first end part (213) and the other end connected to the braided copper mesh (141).

5. The charging device according to claim 4, further comprising a first crimping member (700) and two first anti-leakage rings (800), wherein one of the first anti-leakage rings (800) is sleeved outside the braided copper mesh (141) and located at a joint between the first ferrule (600) and the braided copper mesh (141), the other first anti-leakage ring (800) is sleeved on the first end part (213), and the first crimping member (700) is sleeved on the braided copper mesh (141), the first end part (213) and the two first anti-leakage rings (800).

6. The charging device according to claim 1, wherein the station connector (400) further comprises:
a station connector body (430), the second liquid return channel (410) being located in the station connector body (430), and the connection part (420) communicating to one end of the second liquid return channel (410) and being electrically connected to the braided copper mesh (141);
an adapting part (440), communicating to the other end of the second liquid return channel (410) and communicating to the communicating pipe (500);
a station connection part (450), connected to the station connector body (430) and electrically connected to the charging module (320); and
a cover plate 460 connected to the station connector body (430) and covering the second liquid return channel (410).

7. The charging device according to claim 6, further comprising a second ferrule (610), having one end connected to the connection part (420) and the other end connected to the braided copper mesh (141).

8. The charging device according to claim 7, further comprising a second crimping member (710) and two second anti-leakage rings (810), wherein one of the second anti-leakage rings (810) is sleeved outside the braided copper mesh (141) and located at a joint between the second ferrule (610) and the braided copper mesh (141), the other second anti-leakage ring (810) is sleeved on the connection part (420), and the second crimping member (710) is sleeved on the braided copper mesh (141), the connection part (420) and the two second anti-leakage rings (810).

9. The charging device according to claim 1, wherein the braided copper mesh (141) is a double-layer braided structure or a multi-layer braided structure.

10. The charging device according to claim 1, wherein a braiding density of the braided copper mesh (141) ranges from 70% to 90%.

11. A liquid cooled cable (100) having a gun end (110) and a station end (120), comprising:
a first insulating tube (130), having a first channel (130a);
a second insulating tube (140), having a second channel (140a) and a braided copper mesh (141), the second channel (140a) being located in the braided copper mesh (141);
a tape (150), covering the first insulating tube (130) and the second insulating tube (140);
a filler (160), located in the tape (150) and filled between the first insulating tube (130) and the second insulating tube (140); and
a sheath (170), covering the tape (150).

12. The liquid cooled cable (100) according to claim 11, wherein the liquid cooled cable (100) further comprises a charging gun (200), the charging gun (200) comprising a gun connector (210) and a first liquid return channel (220), the gun connector (210) being electrically connected to the braided copper mesh (141), and the first liquid return channel (220) communicating to the first channel (130a) and the second channel (140a).

13. The liquid cooled cable (100) according to claim 11, wherein the liquid cooled cable (100) further comprises a station connector (400), the station connector (400) comprising a second liquid return channel (410) and a connection part (420), one end of the second liquid return channel (410) communicating to the second channel (140a), and the connection part (420) being electrically connected to the braided copper mesh (141).

14. The liquid cooled cable (100) according to claim 11, wherein the liquid cooled cable (100) further comprises two first insulating tubes (130) and two second insulating tubes (140).

15. The liquid cooled cable (100) according to claim 14, wherein the liquid cooled cable (100) further comprises a charging gun (200), the charging gun (200) comprising two gun connectors (210) and two first liquid return channels (220), each of the gun connectors (210) being electrically connected to one of the braided copper meshes (141), and each of first liquid return channels (220) communicating to one of the first channels (130a) and one of the second channels (140a).

16. The liquid cooled cable (100) according to claim 14, wherein the liquid cooled cable (100) further comprises two station connectors (400), each of the station connectors (400) comprising a second liquid return channel (410) and a connection part (420), one end of the second liquid return channel (410) communicating to one of the second channels (140a), and the connection part (420) being electrically connected to one of the braided copper meshes (141).

17. The liquid cooled cable (100) according to claim 11, wherein the braided copper mesh (141) is a double-layer braided structure or a multi-layer braided structure.

18. The liquid cooled cable (100) according to claim 11, wherein a braiding density of the braided copper mesh (141) ranges from 70% to 90%.

## Amended claims

### Amended claims in accordance with Rule 137(2) EPC.

1. A charging device, comprising:
a liquid cooled cable (100) having a gun end (110) and a station end (120), comprising:
a first insulating tube (130), having a first channel (130a);
a second insulating tube (140), having a second channel (140a) and a braided copper mesh (141), the second channel (140a) being located in the braided copper mesh (141), the braided copper mesh (141) is shaped a hollow tube inside the second insulating tube (140);
a tape (150), covering the first insulating tube (130) and the second insulating tube (140);
a filler (160), located in the tape (150) and filled between the first insulating tube (130) and the second insulating tube (140); and
a sheath (170), covering the tape (150);
a charging gun (200), connected to the gun end (110) of the liquid cooled cable (100) and comprising a gun connector (210) and a first liquid return channel (220), the gun connector (210) being electrically connected to the braided copper mesh (141), and the first liquid return channel (220) communicating to the first channel (130a) and the second channel (140a);
a charging station (300), comprising:
a cooling module (310), comprising a liquid inlet (311) and a liquid outlet (312), the liquid inlet (311) being connected to the station end (120) of the liquid cooled cable (100) and communicating to the first channel (130a); and
a charging module (320);
a station connector (400), comprising a second liquid return channel (410) and a connection part (420), one end of the second liquid return channel (410) communicating to the second channel (140a), and the connection part (420) being connected to the station end (120) of the liquid cooled cable (100) and electrically connected to the braided copper mesh (141); and
a communicating pipe (500), two ends of the communicating pipe (500) respectively communicating to the other end of the second liquid return channel (410) and the liquid outlet (312) of the cooling module (310).

2. The charging device according to claim 1, wherein the liquid cooled cable (100) comprises two first insulating tubes (130) and two second insulating tubes (140).

3. The charging device according to claim 1, wherein the gun connector (210) further comprises:
a gun connector body (211), the first liquid return channel (220) being located in the gun connector body (211);
a gun connection part (212), connected to the gun connector body (211);
a first end part (213), communicating to one end of the first liquid return channel (220) and electrically connected to the braided copper mesh (141);
a second end part (214), communicating to the other end of the first liquid return channel (220) and communicating to the first channel (130a); and
a lid (215), connected to the gun connector body (211) and covering the first liquid return channel (220).

4. The charging device according to claim 3, further comprising a first ferrule (600), having one end connected to the first end part (213) and the other end connected to the braided copper mesh (141).

5. The charging device according to claim 4, further comprising a first crimping member (700) and two first anti-leakage rings (800), wherein one of the first anti-leakage rings (800) is sleeved outside the braided copper mesh (141) and located at a joint between the first ferrule (600) and the braided copper mesh (141), the other first anti-leakage ring (800) is sleeved on the first end part (213), and the first crimping member (700) is sleeved on the braided copper mesh (141), the first end part (213) and the two first anti-leakage rings (800).

6. The charging device according to claim 1, wherein the station connector (400) further comprises:
a station connector body (430), the second liquid return channel (410) being located in the station connector body (430), and the connection part (420) communicating to one end of the second liquid return channel (410) and being electrically connected to the braided copper mesh (141);
an adapting part (440), communicating to the other end of the second liquid return channel (410) and communicating to the communicating pipe (500);
a station connection part (450), connected to the station connector body (430) and electrically connected to the charging module (320); and
a cover plate (460), connected to the station connector body (430) and covering the second liquid return channel (410).

7. The charging device according to claim 6, further comprising a second ferrule (610), having one end connected to the connection part (420) and the other end connected to the braided copper mesh (141).

8. The charging device according to claim 7, further comprising a second crimping member (710) and two second anti-leakage rings (810), wherein one of the second anti-leakage rings (810) is sleeved outside the braided copper mesh (141) and located at a joint between the second ferrule (610) and the braided copper mesh (141), the other second anti-leakage ring (810) is sleeved on the connection part (420), and the second crimping member (710) is sleeved on the braided copper mesh (141), the connection part (420) and the two second anti-leakage rings (810).

9. The charging device according to claim 1, wherein the braided copper mesh (141) is a double-layer braided structure or a multi-layer braided structure.

10. The charging device according to claim 1, wherein a braiding density of the braided copper mesh (141) ranges from 70% to 90%.
